# EUROPEAN PATENT APPLICATION

(11) **EP 3 422 404 A1**
(43) Date of publication of application: **02.01.2019**
(21) Application number: 18161431.4
(22) Date of filing: 13.03.2018
(51) Int. Cl.: H01L 23/49, H01L 23/433, H01L 25/065, H01L 25/18, H01L 23/31, H01L 25/16, H01L 23/367

(54) **SEMICONDUCTOR PACKAGE HAVING MULTI-TIER BONDING WIRES AND COMPONENTS DIRECTLY MOUNTED ON THE MULTI-TIER BONDING WIRES**

(30) Priority: 30.06.2017 US 201762527186 P; 12.02.2018 US 201815894874
(71) Applicant: MediaTek Inc., Hsin-chu 300 (TW)
(72) Inventor: TSAI, Shiann-Tsong, 300 Hsinchu City (TW)
(74) Representative: Hoefer & Partner Patentanwälte mbB

(57) **Abstract**

A semiconductor package includes a carrier substrate (10) having a top surface, a semiconductor die (20) mounted on the top surface, a plurality of bonding wires (30) connecting an active surface of the semiconductor die (20) to the top surface of the carrier substrate (10), an insulating material (41) encapsulating the plurality of bonding wires (30), a component (200) mounted on the insulating material (41), and a molding compound (50) covering the top surface of the carrier substrate (10) and encapsulating the semiconductor die (20), the plurality of bonding wires (30), the component (200) and the insulating material (41).

## Description

### Background

The present disclosure relates generally to the field of semiconductor packaging. More particularly, the present disclosure relates to a semiconductor integrated circuit (IC) package with multi-tier bonding wires and component(s) stacked directly on the multi-tier bonding wires.

In the integrated circuit (IC) packaging industry, there is a continuous desire to provide higher and higher density IC packages for semiconductor die having increasing numbers of input/output (I/O) terminal pads. When using a conventional wire bonding packaging technique, the pitch, or spacing between adjacent bonding wires becomes finer and finer as the number of I/O terminal pads increases for a given size die.

During the molding or encapsulation of a plastic IC package, the flow of a plastic molding compound melt into a mold cavity exerts forces sufficiently high as to displace or deform the bonding wires, hence resulting in bonding wire sweep or mold wire sweep. The wire deformation causes adjacent bond wires to come into contact with each other, which results in shorting between adjacent wires.

Although a variety of approaches have been suggested for reducing the bonding wire sweep during the encapsulating process of an IC package, many of these approaches require additional process steps or require specialized equipment. These requirements for additional process steps or specialized equipment add to the costs of producing the package and are therefore undesirable.

### Summary

It is an object of the invention to provide an improved semiconductor package having stabilized, insulator-coated bonding wires in order to solve the above-mentioned prior art problems and shortcomings.

The object is solved by the features of the independent claim. The dependent claims disclose further developments of the invention.

According to the invention, the semiconductor package includes a carrier substrate having a top surface, a semiconductor die mounted on the top surface, a plurality of bonding wires (first bonding wires connecting an active surface of the semiconductor die to the top surface of the carrier substrate, an insulating material encapsulating the plurality of bonding wires, a component mounted on the insulating material, and a molding compound covering the top surface of the carrier substrate and encapsulating the semiconductor die, the plurality of bonding wires, the component and the insulating material. The component may comprise a dummy silicon die, a piece of metal, or a heat sink.

According to a preferred embodiment, the semiconductor package includes the carrier substrate having a top surface, the semiconductor die mounted on the top surface, the plurality of first bonding wires connecting the semiconductor die to the carrier substrate, the insulating material encapsulating the plurality of first bonding wires, the component mounted on the insulating material, a plurality of second bonding wires connecting the component to the carrier substrate, and the molding compound covering the top surface of the carrier substrate and encapsulating the semiconductor die, the component, the plurality of first bonding wires, the plurality of second bonding wires, and the insulating material. The component may comprise a semiconductor die or a passive device.

According to a preferred embodiment, the semiconductor package includes the carrier substrate having a top surface, the semiconductor die mounted on the top surface, the plurality of first bonding wires connecting the semiconductor die to the carrier substrate, the insulating material encapsulating the plurality of first bonding wires, a further semiconductor die as the component mounted on the insulating material, a plurality of second bonding wires connecting the further semiconductor die to the carrier substrate, a further insulating material encapsulating the plurality of second bonding wires, a further component mounted on the further insulating material, and the molding compound covering the top surface of the carrier substrate and encapsulating the further component, the first semiconductor die, the second semiconductor die (component), the plurality of first bonding wires, the plurality of second bonding wires, the insulating material, and the further insulating material. The further component preferably comprises a passive device. A plurality of third bonding wires may be provided for connecting the further component to the carrier substrate.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention, and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary semiconductor package with coated bonding wires according to the invention;
FIG. 2 is a schematic, perspective view of two adjacent bonding wires in FIG. 1 without the molding compound for clarity;
FIG. 3 is a schematic, cross-sectional diagram showing the two adjacent bonding wires and the coated insulating material;
FIG. 4 to FIG. 7 are schematic, cross-sectional diagrams showing an exemplary method for forming the semiconductor package with coated bonding wires according to the invention;
FIG. 8 is a schematic top view of the semiconductor package showing an exemplary region around the semiconductor die, in which the insulating material is sprayed;
FIG. 9 is a schematic, cross-sectional diagram showing a dipping process for coating an insulating material onto the bonding wires according to the invention;
FIG. 10 is a schematic top view of a semiconductor IC package according to the invention;
FIG. 10A is a schematic top view of a semiconductor package according to the invention;
FIG. 11 is a schematic, cross-sectional view taken along line I-I' in FIG. 10;
FIG. 12 shows the semiconductor IC package after molding;
FIG. 13 is a schematic top view of a semiconductor package according to the invention;
FIG. 14 is a schematic, cross-sectional view taken along line II-II' in FIG. 13.
FIG. 15 is a schematic, cross-sectional view of a semiconductor package according to the invention;
FIG. 16 is a schematic, cross-sectional view of a semiconductor package according to the invention; and
FIG. 17 is a schematic, cross-sectional view of a semiconductor package according to the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made.

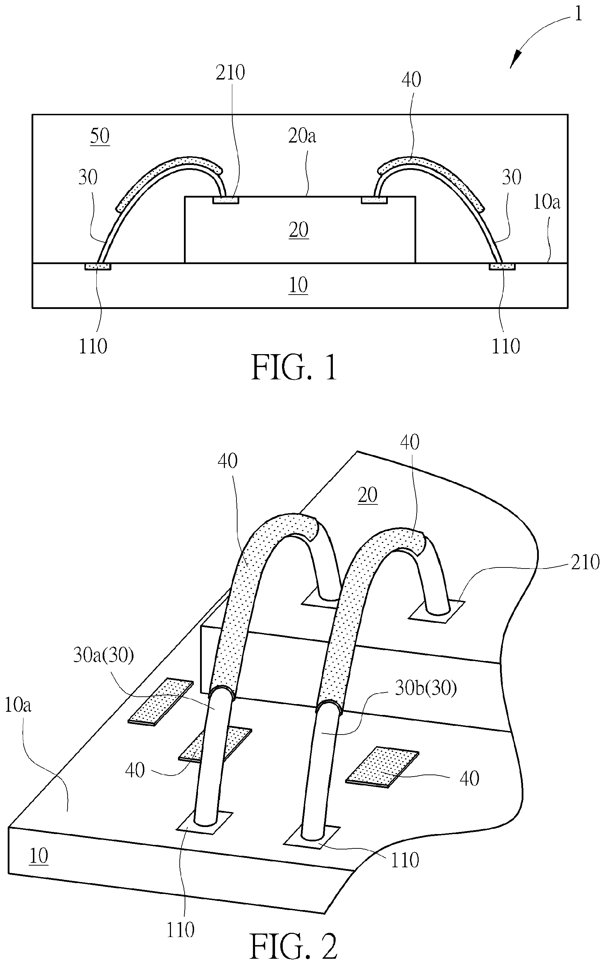

Please refer to FIG. 1 and FIG. 2. FIG. 1 is a schematic, cross-sectional diagram showing an exemplary semiconductor package with coated bonding wires according to the invention. FIG. 2 is a schematic, perspective view of two adjacent bonding wires in FIG. 1 without the molding compound for clarity.

As shown in FIG. 1 and FIG. 2, the semiconductor package 1 comprises a carrier substrate 10 having a top surface 10a. A semiconductor die 20 is mounted on the top surface 10a. The semiconductor die 20 has an active surface 20a, on which a plurality of input/output (I/O) pads 210 is distributed. According to the illustrative embodiment, the semiconductor die 20 is electrically connected to the bond fingers 110 on the top surface 10a of the carrier substrate 10 through a plurality of bonding wires 30 (first bonding wires). According to the illustrative embodiment, the bonding wires 30 may comprise copper, gold, silver, or any suitable conductive materials. According to the illustrative embodiment, the carrier substrate 10 may comprise a packaging substrate, an interposer substrate, or a leadframe substrate, but is not limited thereto.

According to the illustrative embodiment, the bonding wires 30 are partially coated with an insulating material 40. According to the illustrative embodiment, the insulating material 40 may comprise polymers, epoxy, or resins, but is not limited thereto. The insulating material 40 coated on the bonding wires 30 may be cured to provide the bonding wires 30 with extra mechanical support. The insulating material 40 secures the bonding wires 30 and is able to resist the mold wire sweep during the encapsulation process of the semiconductor package 1. According to the illustrative embodiment, the insulating material 40 has low permittivity or low dielectric constant (low-k) that can prevent shorting and alleviate crosstalk between adjacent wires. In other embodiments, the bonding wires 30 may be fully coated with the insulating material 40 to provide a more desirable isolation effect.

According to the illustrative embodiment, the semiconductor package 1 further comprises a molding compound 50 on the top surface 10a of the carrier substrate 10. The molding compound 50 encapsulates the bonding wires 30, the insulating material 40, and the semiconductor die 20. According to the illustrative embodiment, the molding compound 50 may comprise an epoxy resin and a filler material, but is not limited thereto. According to the illustrative embodiment, the insulating material 40 may have the same epoxy composition as that of the molding compound 50, but without the filler material or with lower content of the filler material. According to the illustrative embodiment, the insulating material 40 contains less than 50ppm halogen content in order to prevent corrosion of the bonding wires 30. According to another embodiment, the insulating material 40 may have a composition that is different from that of the molding compound 50.

As shown in FIG. 2, only two adjacent bonding wires 30a and 30b are illustrated for the sake of simplicity. The insulating material 40 is partially coated on the portions of the two adjacent bonding wires 30a and 30b that are most likely to short to the adjacent wires during the wire sweep that occurs during the encapsulation process of the semiconductor package 1. According to the illustrative embodiment, the insulating material 40 may be also formed on the top surface 10a of the carrier substrate 10 or elsewhere in the semiconductor package 1. The insulating material 40 formed on the top surface 10a of the carrier substrate 10 may enhance the interface adhesive strength between the molding compound 50 and the carrier substrate 10.

The two adjacent bonding wires 30a and 30b may have different loop heights. It is advantageous to use the present invention because the insulating material 40 coated on the bonding wires 30a and 30b can avoid abnormal wire sweep during encapsulation process and provide significant isolation effect. Furthermore, the loop heights of the two adjacent bonding wires 30a and 30b may be reduced such that more wires can be arranged in the same space.

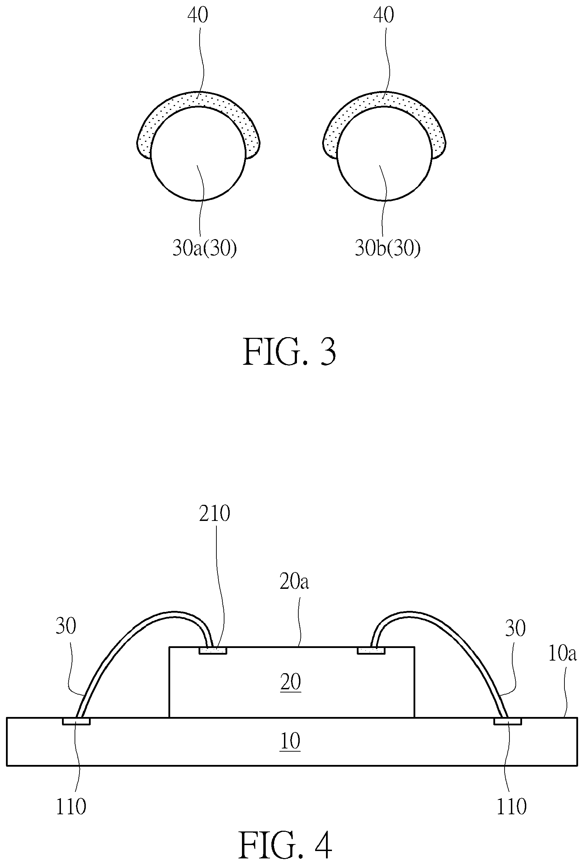

FIG. 3 is a schematic, cross-sectional diagram showing the two adjacent bonding wires and the coated insulating material. As shown in FIG. 3, according to the illustrative embodiment, the insulating material 40 may only cover at least a partial portion, for example upper half portion, of each of the bonding wires 30 when viewed in cross-sections of the bonding wires 30. According to the illustrative embodiment, the lower half portion of each of the bonding wires 30 is not covered by the insulating material 40. However, it is understood that, in some embodiments, each of the bonding wires 30 may be wrapped around by the insulating material 40.

FIG. 4 to FIG. 7 are schematic, cross-sectional diagrams showing an exemplary method for forming the semiconductor package with coated bonding wires according to the invention, wherein like numeral numbers designate like layers, regions, or elements. As shown in FIG. 4, the semiconductor die 20 is mounted on a top surface 10a of the carrier substrate 10. According to the illustrative embodiment, the carrier substrate 10 may comprise a packaging substrate, an interposer substrate, or a leadframe substrate, but is not limited thereto. The semiconductor die 20 may be adhered to the top surface 10a by using an adhesive (not explicitly shown), but is not limited thereto. According to the illustrative embodiment, the semiconductor die 20 is electrically connected to the bond fingers 110 on the top surface 10a of the carrier substrate 10 through a plurality of bonding wires 30.

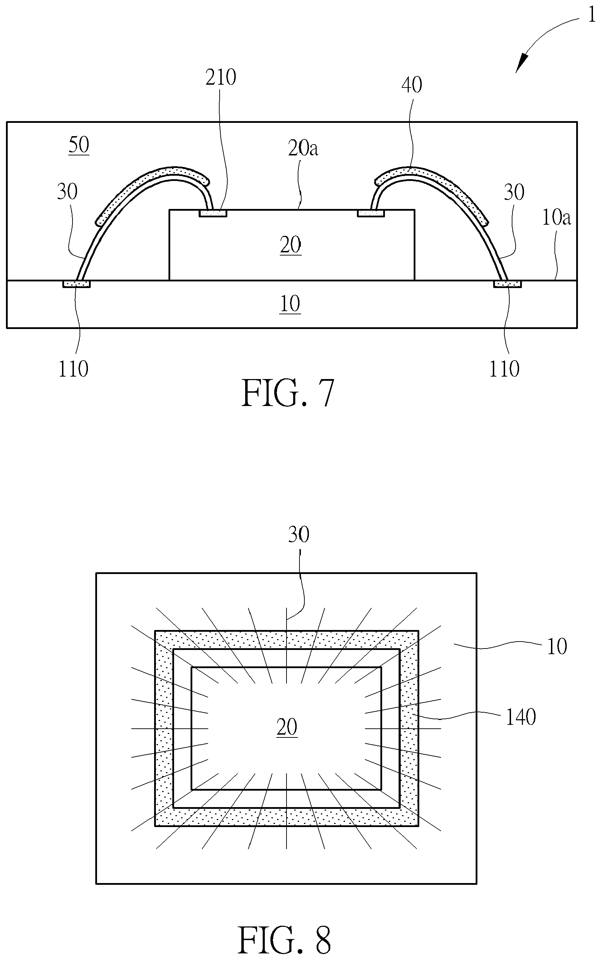

After the wire-bonding process, the insulating material 40 is sprayed onto the bonding wires 30 within predetermined regions. For example, referring to FIG. 8, a region 140 is demonstrated around the semiconductor die 20. The insulating material 40 may be sprayed onto the bonding wires 30 within the region 140 that would be most likely to short to the adjacent wires during the encapsulation process. According to the illustrative embodiment, the insulating material 40 may be sprayed onto the top surface 10a of the carrier substrate 10 or onto the active surface 20a of the semiconductor die 20, which may enhance the interface adhesive strength between the molding compound and the substrate surface/ die surface. It is understood the region 140 shown in FIG. 8 is for illustration purposes only.

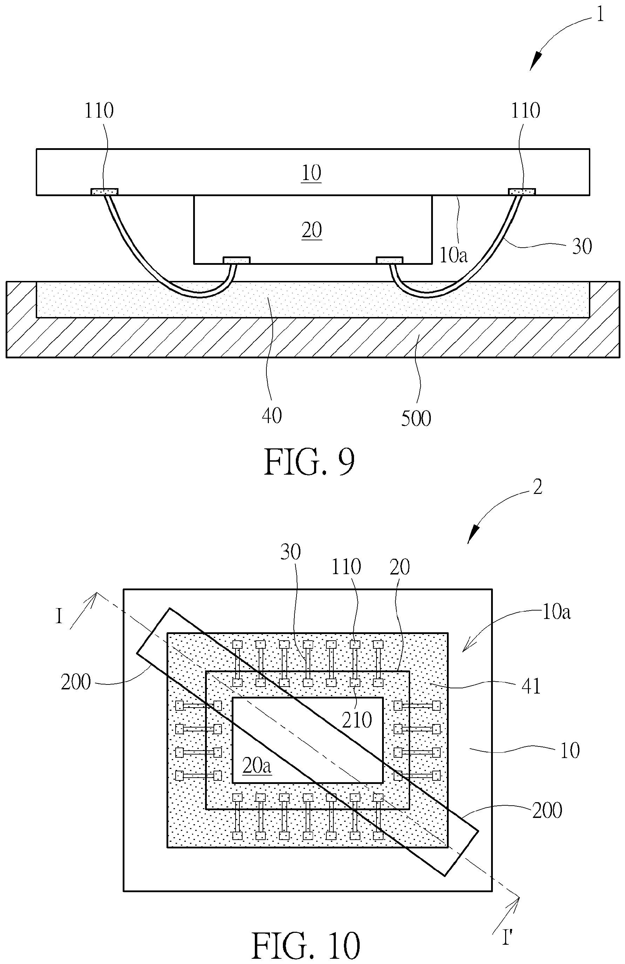

According to the illustrative embodiment, the insulating material 40 may be sprayed onto the bonding wires 30 by using a jet sprayer 400 or the like. However, in some embodiments, the insulating material 40 may be coated onto the bonding wires 30 by using a dipping process . For example, referring to FIG. 9, a container 500 contains the insulating material 40 in liquid phase. The package 1 is flipped and the bonding wires 30 may be partially dipped into the insulating material 40 to coat the bonding wires 30. Subsequently, a drying process or baking process may be performed to remove the solvent.

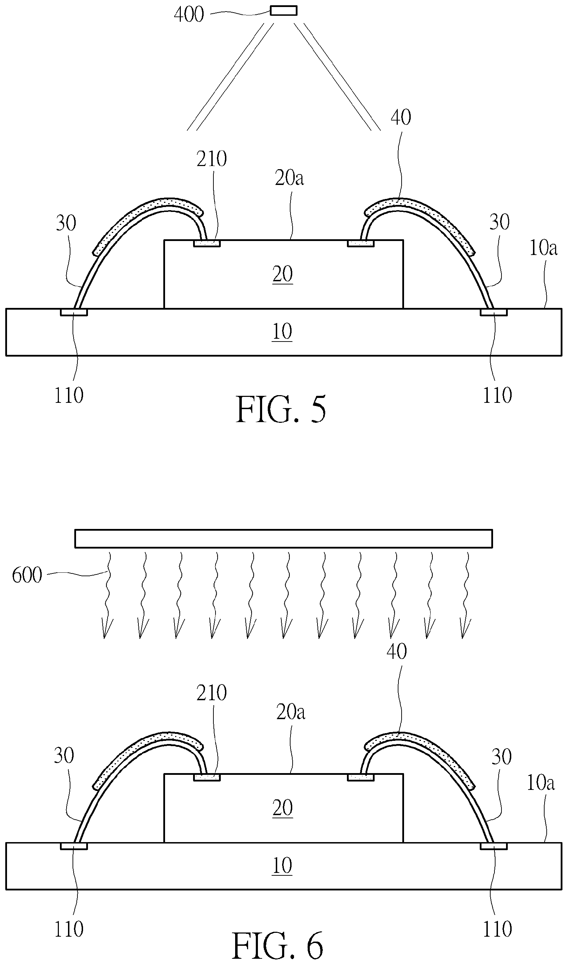

As shown in FIG. 6, after spraying the insulating material 40, an optional curing process 600 may be carried out to cure the insulating material 40. According to the illustrative embodiment, the curing process 600 may be carried out in an oven or under actinic radiation conditions, but is not limited thereto. For example, the curing process 600 may be a fast curing process under ultraviolet (UV) or infrared (IR) irradiation. It is understood that the curing process 600 may be skipped in some embodiments, and the insulating material 40 may be cured at a later stage, together with the molding compound.

As shown in FIG. 7, a molding compound 50 is formed on the top surface 10a of the carrier substrate 10 to encapsulate the bonding wires 30, the insulating material 40, and the semiconductor die 20. According to the illustrative embodiment, the molding compound 50 may comprise an epoxy resin and a filler material, but is not limited thereto. According to the illustrative embodiment, the insulating material 40 may have the same epoxy composition as that of the molding compound 50, but without the filler material or with lower content of the filler material. According to the illustrative embodiment, the insulating material 40 contains less than 50ppm halogen content in order to prevent corrosion of the bonding wires 30.

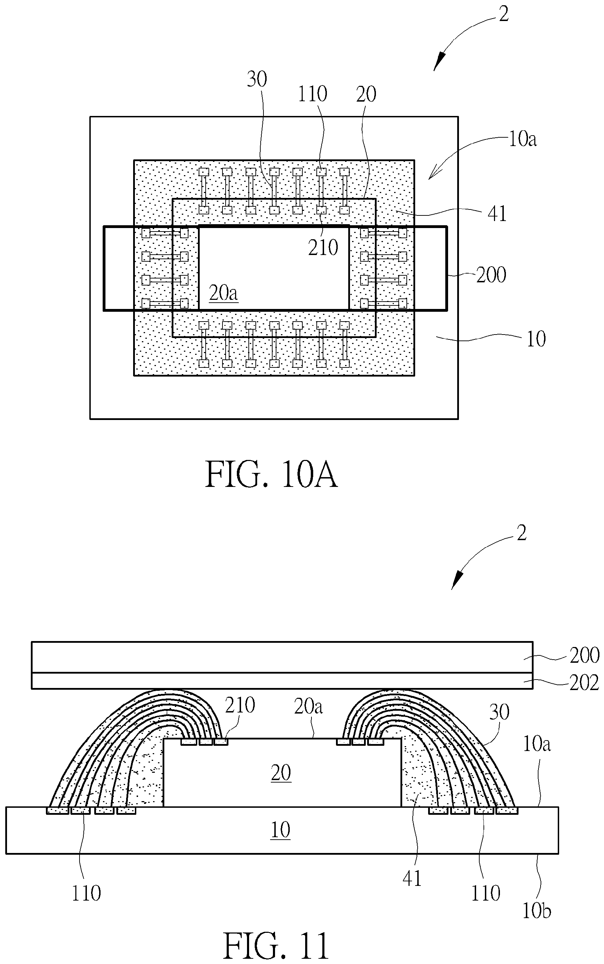

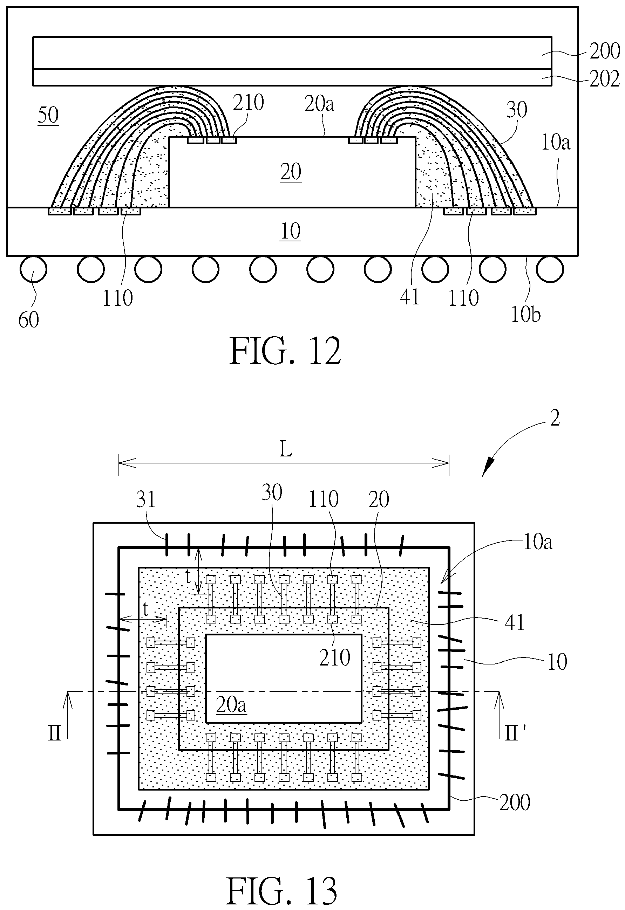

Please refer to FIG. 10 to FIG. 12. FIG. 10 is a schematic top view of the semiconductor package 1 according to the invention. FIG. 11 is a schematic, cross-sectional view taken along line I-I' in FIG. 10. FIG. 12 shows the semiconductor package after molding. Like layers, regions or elements are designated by like numeral numbers.

As shown in FIG. 10 and FIG. 11, the semiconductor package 2 comprises a carrier substrate 10 having a top surface 10a and a bottom surface 10b. A semiconductor die 20 is mounted on the top surface 10a. The semiconductor die 20 has an active surface 20a, on which a plurality of input/output (I/O) pads 210 is distributed. According to the illustrative embodiment, the semiconductor die 20 is electrically connected to the bond fingers 110 on the top surface 10a of the carrier substrate 10 through multi-tier bonding wires 30 (first bonding wires) . According to the illustrative embodiment, the bonding wires 30 may comprise copper, gold, silver, or any suitable conductive materials. According to the illustrative embodiment, the carrier substrate 10 may comprise a packaging substrate or an interposer substrate, but is not limited thereto.

According to the illustrative embodiment, an insulating material 41 is applied to the bonding wires 30. For example, the insulating material 41 may be applied in a rectangular, ring shape around or about the semiconductor die 20, but is not limited thereto. The insulating material 41 may completely cover the multi-tier bonding wires 30 and is in direct contact with only a peripheral region of the active surface 20a. However, it is understood that the insulating material 41 may covers only a portion of the bonding wires 30. The ring-shaped insulating material 41 may be continuous or may be discontinuous. According to the illustrative embodiment, the insulating material 41 may be in direct contact with the sidewalls of the semiconductor die 20.

According to the illustrative embodiment, the insulating material 41 may comprise polymers, epoxy, fillers, or resins, but is not limited thereto. The insulating material 41 coated on the bonding wires 30 may be cured to provide the bonding wires 30 with extra mechanical support. The insulating material 41 secures the bonding wires 30 and is able to resist the mold wire sweep during the subsequent encapsulation process. According to the illustrative embodiment, the insulating material 41 has low permittivity or low dielectric constant (low-k) that can prevent shorting and alleviate crosstalk between adjacent wires.

According to the illustrative embodiment, a component 200 is mounted directly on the insulating material 41. For example, the component 200 may be a dummy silicon die, a piece of metal, or a heat sink, but is not limited thereto. The component 200 may be attached to the insulating material 41 by using an adhesive or a glue layer 202. According to the illustrative embodiment, the component 200 may have a slender shape and its longer axis may extend along the diagonal direction of the semiconductor package 2, as can be seen in FIG. 10. The mold flow direction may be orthogonal to the longer axis of the component 200. According to another embodiment, as shown in FIG. 10A, the longer side of the component 200 may be in parallel with the longer side of the semiconductor package 2.

As shown in FIG. 12, a molding compound 50 is formed on the top surface 10a of the carrier substrate 10 to encapsulate the bonding wires 30, the insulating material 41, the component 200, and the semiconductor die 20. According to the illustrative embodiment, the molding compound 50 may comprise an epoxy resin and a filler material, but is not limited thereto. According to the illustrative embodiment, the insulating material 41 may have the same epoxy composition as that of the molding compound 50, but without the filler material or with lower content of the filler material. According to the illustrative embodiment, the insulating material 41 and the molding compound 50 have different compositions. According to the illustrative embodiment, the insulating material 41 contains less than 50ppm halogen content in order to prevent corrosion of the bonding wires 30. After the molding compound 50 is formed, connection elements 60 such as solder balls are formed on the bottom surface 10b.

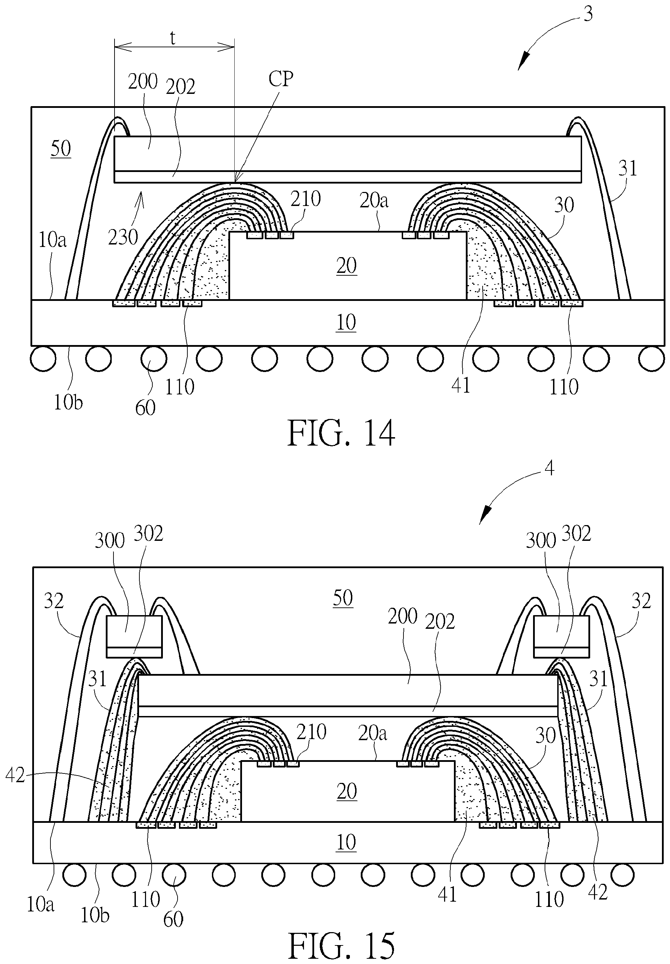

FIG. 13 is a schematic top view of a semiconductor package according to another embodiment of the invention. FIG. 14 is a schematic, cross-sectional view taken along line II-II' in FIG. 13. Like layers, regions, or elements are designated by like numeral numbers. As shown in FIG. 13 and FIG. 14, likewise, the semiconductor package 3 comprises a component 200 directed mounted on the insulating material 41. According to the illustrative embodiment, the component 200 may be a semiconductor die and is wired bonded to the carrier substrate 10 through the bonding wires 31. The component 200 completely overlaps with the underlying semiconductor die 20. As cane be seen in FIG. 13, the surface area of the component 200 is greater than that of the underlying semiconductor die 20. The component 200 has a length L. The component 200 is supported by the insulating material 41 and the bonding wires 30, 31. An overhang 230 having a distance t between an edge of the component 200 and the contact point CP between the component 200 and the insulating material 41 is shown in FIG. 14.

The overhang distance t may be greater than 1/3L and may be smaller than 1/2L.

The molding compound 50 is formed on the top surface 10a of the carrier substrate 10 to encapsulate the bonding wires 30, 31, the insulating material 41, the component 200, and the semiconductor die 20. The molding compound 50 may be formed by transfer mold or compression mold, but is not limited thereto.

FIG. 15 is a schematic, cross-sectional view of a semiconductor package according to still another embodiment of the invention, wherein like layers, regions, or elements are designated by like numeral numbers. As shown in FIG. 15, likewise, the semiconductor package 4 comprises a component 200 directed mounted on the insulating material 41. According to the illustrative embodiment, the component 200 may be a semiconductor die and is wired bonded to the carrier substrate 10 through the bonding wires 31. According to the illustrative embodiment, an insulating material 42 may be applied to the bonding wires 31 so as to secure the bonding wires 31 and provide the bonding wires 31 with extra mechanical support. According to the illustrative embodiment, components 300 may be mounted directly on the insulating material 42 via adhesive layers 302. For example, the components 300 may comprise discrete passive devices including, but not limited to, capacitors, resistors or inductors. According to the illustrative embodiment, components 300 may be wire bonded to the carrier substrate 10 and/or the component 200 through the bonding wires 32. The molding compound 50 is formed on the top surface 10a of the carrier substrate 10 to encapsulate the bonding wires 30, 31, 32, the insulating material 41, 42, the component 200, the components 300, and the semiconductor die 20.

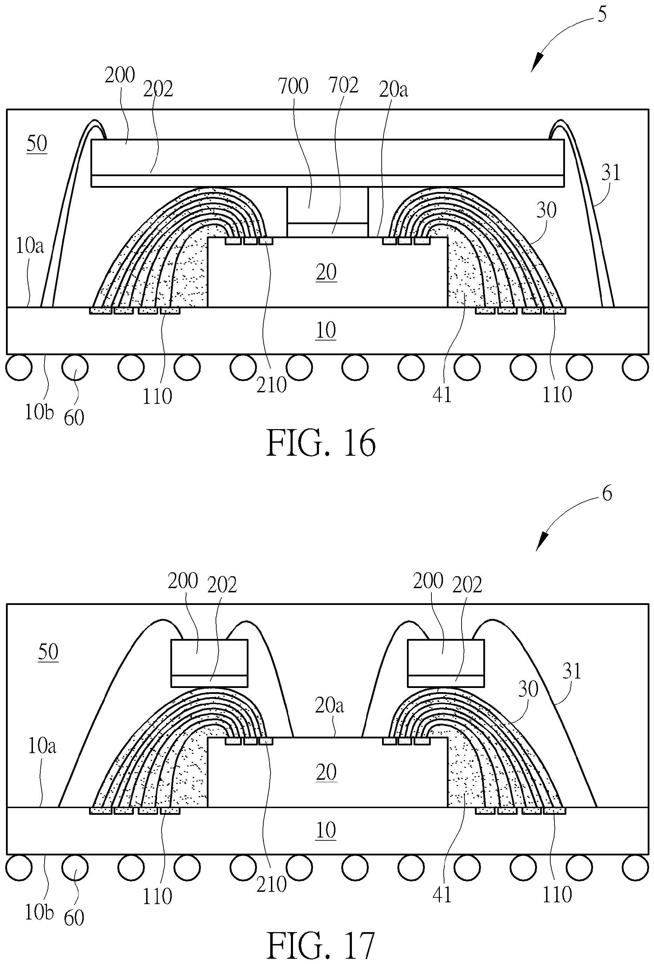

FIG. 16 is a schematic, cross-sectional view of a semiconductor package according to still another embodiment of the invention, wherein like layers, regions, or elements are designated by like numeral numbers. As shown in FIG. 16, the difference between the semiconductor package 5 in FIG. 16 and the semiconductor package 3 in FIG. 14 is that the semiconductor package 5 in FIG. 16 comprises a spacer 700 between the component 200 and the semiconductor die 20. The spacer 700 may be adhered to the active surface 20a of the semiconductor die 20 by using an adhesive layer 702.

FIG. 17 is a schematic, cross-sectional view of a semiconductor package according to still another embodiment of the invention, wherein like layers, regions, or elements are designated by like numeral numbers. As shown in FIG. 17, the semiconductor package 6 comprises components 200 directed mounted on the insulating material 41. According to the illustrative embodiment, the components 200 may comprise a semiconductor die or a passive device such as a capacitor, a resistor or an inductor. The components 200 may be wired bonded to the carrier substrate 10 and/or the semiconductor die 20 through the bonding wires 31. The molding compound 50 is formed on the top surface 10a of the carrier substrate 10 to encapsulate the bonding wires 30, 31, the insulating material 41, the components 200, and the semiconductor die 20.

Those skilled in the art will readily observe that numerous modifications and alterations of the device and method may be made while retaining the teachings of the invention. Accordingly, the above disclosure should be construed as limited only by the metes and bounds of the appended claims.

The invention is also disclosed by the following clauses:
1. A semiconductor package, comprising:
   a carrier substrate having a top surface;
   a semiconductor die mounted on the top surface;
   a plurality of bonding wires connecting an active surface of the semiconductor die to the top surface of the carrier substrate;
   an insulating material encapsulating the plurality of bonding wires;
   a component mounted on the insulating material; and
   a molding compound covering the top surface of the carrier substrate and encapsulating the semiconductor die, the plurality of bonding wires, the component and the insulating material.
2. The semiconductor package according to clause 1, wherein the component comprises a dummy silicon die, a piece of metal, or a heat sink.
3. The semiconductor package according to clause 1, wherein component is attached to the insulating material by an adhesive layer.
4. The semiconductor package according to clause 1, wherein the component has a slender shape and its longer axis extends along the diagonal direction of the semiconductor package.
5. The semiconductor package according to clause 1, wherein a longer side of the component is in parallel with a longer side of the semiconductor package.
6. The semiconductor package according to clause 1, wherein the insulating material is disposed in a rectangular, ring shape around the semiconductor die.
7. The semiconductor package according to clause 6, wherein the rectangular, ring-shaped insulating material is continuous.
8. The semiconductor package according to clause 6, wherein the rectangular, ring-shaped insulating material is discontinuous.
9. The semiconductor package according to clause 1, wherein the insulating material and the molding compound have different compositions.
10. The semiconductor package according to clause 1, wherein the insulating material completely covers the bonding wires and is in direct contact with a peripheral region of the active surface.
11. The semiconductor package according to clause 1, wherein the carrier substrate comprises a packaging substrate or an interposer substrate.
12. A semiconductor package, comprising:
   a carrier substrate having a top surface;
   a semiconductor die mounted on the top surface;
   a plurality of first bonding wires connecting the semiconductor die to the carrier substrate;
   an insulating material encapsulating the plurality of first bonding wires;
   a component mounted on the insulating material;
   a plurality of second bonding wires connecting the component to the carrier substrate; and
   a molding compound covering the top surface of the carrier substrate and encapsulating the semiconductor die, the component, the plurality of first bonding wires, the plurality of second bonding wires, and the insulating material.
13. The semiconductor package according to clause 12, wherein the component comprises a semiconductor die or a passive device.
14. The semiconductor package according to clause 12, wherein the component is attached to the insulating material by an adhesive layer.
15. The semiconductor package according to clause 12, wherein the insulating material is disposed in a rectangular, ring shape around the semiconductor die.
16. The semiconductor package according to clause 12, wherein the insulating material and the molding compound have different compositions.
17. The semiconductor package according to clause 12, wherein the insulating material completely covers the first bonding wires and is in direct contact with a peripheral region of an active surface of the semiconductor die.
18. The semiconductor package according to clause 12, further comprising an overhang between an edge of the component and a contact point between the component and the insulating material.
19. The semiconductor package according to clause 18, wherein the component has a length L, and the overhang has an overhang distance t between the edge of the component and the contact point, and wherein t is greater than 1/3L and smaller than 1/2L.
20. A semiconductor package, comprising:
   a carrier substrate having a top surface;
   a first semiconductor die mounted on the top surface;
   a plurality of first bonding wires connecting the first semiconductor die to the carrier substrate;
   a first insulating material encapsulating the plurality of first bonding wires;
   a second semiconductor die mounted on the first insulating material;
   a plurality of second bonding wires connecting the second semiconductor die to the carrier substrate;
   a second insulating material encapsulating the plurality of second bonding wires;
   a component mounted on the second insulating material; and
   a molding compound covering the top surface of the carrier substrate and encapsulating the component, the first semiconductor die, the second semiconductor die, the plurality of first bonding wires, the plurality of second bonding wires, the first insulating material, and the second insulating material.
21. The semiconductor package according to clause 20, wherein the component comprises a passive device.
22. The semiconductor package according to clause 20 further comprising a plurality of third bonding wires connecting the component to the carrier substrate.

## Claims

1. A semiconductor package (2-6), comprising:
a carrier substrate (10) having a top surface (10a);
a semiconductor die (20) mounted on the top surface (10a);
a plurality of first bonding wires (30) connecting an active surface (20a) of the semiconductor die (20) to the top surface (10a) of the carrier substrate (10);
an insulating material (41) encapsulating the plurality of first bonding wires (30);
a component (200) mounted on the insulating material (41); and
a molding compound (50) covering the top surface (10a) of the carrier substrate (10) and encapsulating the semiconductor die (20), the plurality of first bonding wires (30), the component (200) and the insulating material (41).

2. The semiconductor package according to claim 1, wherein the component (200) comprises a dummy silicon die, a piece of metal, or a heat sink.

3. The semiconductor package according to claim 1, further comprising:
a plurality of second bonding wires (31) connecting the component (200) to the carrier substrate (10),
wherein the molding compound (50) covers the top surface (10a) of the carrier substrate (10) and encapsulating the semiconductor die (20), the component (200), the plurality of first bonding wires (30), the plurality of second bonding wires (31), and the insulating material (41).

4. The semiconductor package according to claim 3, wherein the component (200) comprises a further semiconductor die or a passive device.

5. The semiconductor package according to claim 1, wherein
the component (200) is a further semiconductor die (200) mounted on the insulating material (41);
the package further comprising:
a plurality of second bonding wires (31) connecting the further semiconductor die (200) to the carrier substrate (10);
a further insulating material (42) encapsulating the plurality of second bonding wires (31); and
a further component (300), preferably comprising a passive device, mounted on the further insulating material (42),
wherein the molding compound (50) covers the top surface (10a) of the carrier substrate (10) and encapsulating the further component (300), the first semiconductor die (20), the further semiconductor die (200), the plurality of first bonding wires (30), the plurality of second bonding wires (31), the first insulating material (41), and the further insulating material (42).

6. The semiconductor package according to claim 5, further comprising a plurality of third bonding wires (32) connecting the further component (300) to the carrier substrate (10).

7. The semiconductor package according to any preceding claims, wherein the component (200) is attached to the insulating material (41) by an adhesive layer (202) and/or the further component (300) is attached to the further insulating material (42) by an adhesive layer (302).

8. The semiconductor package according to any preceding claims, wherein the component (200) has a slender shape and its longer axis extends along the diagonal direction of the semiconductor package.

9. The semiconductor package according to any of claims 1 to 7, wherein a longer side of the component (200) is in parallel with a longer side of the semiconductor package.

10. The semiconductor package according to any preceding claims, wherein the insulating material (41) is disposed in a rectangular, ring shape around the semiconductor die (20).

11. The semiconductor package according to claim 10, wherein the rectangular, ring-shaped insulating material (41) is continuous or discontinuous.

12. The semiconductor package according to any preceding claims, wherein the insulating material (41) and the molding compound (50) have different compositions.

13. The semiconductor package according to any preceding claims, wherein the insulating material (41) completely covers the first bonding wires (30) and is in direct contact with a peripheral region of the active surface (20a).

14. The semiconductor package according to any preceding claims, wherein the carrier substrate (10) comprises a packaging substrate or an interposer substrate.

15. The semiconductor package according to any preceding claims, further comprising an overhang (230) between an edge of the component (200) and a contact point (CP) between the component (200) and the insulating material (41), wherein the component (200) has a length L, and the overhang (230) has an overhang distance t between the edge of the component and the contact point (CP), and wherein preferably: t is greater than 1/3L and smaller than 1/2L.
